**Europäisches Patentamt**

**European Patent Office**

**Office européen des brevets**

(19)

(11) Numéro de publication: **0 086 922**
**B1**

(12)

# FASCICULE DE BREVET EUROPÉEN

(45) Date de publication du fascicule du brevet:
**24.09.86**

(51) Int. Cl.⁴: **H 01 L 41/22,** H 04 R 17/00

(21) Numéro de dépôt: **82402346.9**

(22) Date de dépôt: **21.12.82**

(54) Procédé de fabrication de transducteurs piézo-électriques polymères.

(30) Priorité: **31.12.81 FR 8124564**

(43) Date de publication de la demande:
**31.08.83 Bulletin 83/35**

(45) Mention de la délivrance du brevet:
**24.09.86 Bulletin 86/39**

(84) Etats contractants désignés:
**DE GB NL**

(56) Documents cité:
**EP-A-0 013 952**
**EP-A-0 014 043**
**EP-A-0 048 642**
**EP-A-0 056 549**
**GB-A-2 042 256**

(73) Titulaire: **THOMSON- CSF, 173, Boulevard Haussmann, F-75379 Paris Cedex 08 (FR)**

(72) Inventeur: **Broussoux, Dominique, THOMSON- CSF SCPI 173, bld Haussmann, F-75379 Paris Cedex 08 (FR)**
Inventeur: **Facoetti, Hugues, THOMSON- CSF SCPI 173, bld Haussmann, F-75379 Paris Cedex 08 (FR)**
Inventeur: **Micheron, François, THOMSON- CSF SCPI 173, bld Haussmann, F-75379 Paris Cedex 08 (FR)**

(74) Mandataire: **Wang, Pierre, THOMSON- CSF SCPI 173, Bld Haussmann, F-75379 Paris Cedex 08 (FR)**

## Description

La présente demande de brevet concerne les transducteurs électromécaniques utilisant des matériaux polymères piézoélectriques et leur procédé de fabrication. L'effet piézoélectrique engendré dans ce type de transducteur a pour cause la flexion, lorsqu'il s'agit de structures bimorphes.

Les matériaux polymères utilisés dans les transducteurs permettent de créer des déformations de flexion ou des déformations en extension-compression.

Dans le cas où l'on veut privilégier les coefficients piézoélectriques perpendiculairement à l'axe de flexion, il est préférable que les lames piézoélectriques soient du type monoétiré.

Il est connu de la demande de Brevet Européen 14 043 d'étirer dans un premier temps dans un rapport 1 à 4 un film de polymère susceptible d'acquérir des propriétés piézoélectriques. Cet étirement se fait par traction à chaud, par exemple en enroulant le film sur un cylindre quatre fois plus vite qu'on ne le déroule d'un autre cylindre. Dans un second temps le film est maintenu entre deux courroies sans fin en caoutchouc conducteur cependant qu'il est chauffé. On applique alors une tension électrique entre les deux courroies, ce qui permet de polariser le film et de le rendre piézoélectrique. Dans un troisième temps on peut déposer sur les deux faces du film des électrodes en élastomère rendu conducteur par incorporation d'une poudre conductrice. Pour appliquer ces électrodes, l'électromère qui les constitue peut être dissout. Une telle méthode est longue et ne peut s'appliquer à des lames épaisses qui ne s'enrouleraient pas sur les cylindres.

La Demanderesse a décrit dans le Brevet Européen 48 642 non publié à la date de dépôt de la présente demande un procédé dans lequel les matériaux polymères sont polarisés par passage dans un laminoir en présence d'un champ électrique. L'un des modes de réalisation consiste à colaminer au moins deux lames polymères tout en les polarisant, les rouleaux du laminoir servant alors d'électrodes d'application du champ électrique.

Dans le cas où l'on désire des polarisations rémanentes de sens opposé, il est avantageux d'appliquer la tension nécessaire au champ électrique de polarisation entre une électrode intermédiaire et la masse, les rouleaux lamineurs étant alors reliés à la masse.

Le problème le plus délicat à résoudre lors du laminage consiste a faire en sorte que l'électrode intermédiaire garde ses qualités électriques malgré les contraintes imposées par les rouleaux. En effet, les forces mises en oeuvre entre les rouleaux sont de l'ordre de $4.10^5$ à $10^6$ N (40 à 100 tonnes), le taux d'étirement peut aller jusqu'à 3 ou 4 ce qui peut provoquer des cassures dans la masse de l'électrode. L'électrode intermédiaire nécessaire à l'opération de polarisation est alors une électrode fluide. Dans ce cas, un liant conducteur peut être ajouté après l'opération de laminage afin de réaliser une électrode intermédiaire utilisable et d'obtenir une structure monolithique. Si cette opération est réalisée après le laminage sous champ électrique certaines propriétés piézoélectriques des matériaux polymères seront altérées à cause du pressage à chaud nécessaire pour effectuer un collage efficace.

Afin de pallier ces inconvénients, l'invention propose un procédé de fabrication d'un transducteur en polymère rendu piézoélectrique par étirage mécanique à chaud et polarisation simultanée sous l'action d'un champ électrique, caractérisé en ce qu'on réalise d'abord une préforme composée de deux couches externes de matériau polymère susceptible d'acquérir des propriétés piézoélectriques séparées par une couche interne, constituée d'un matériau polymère rendu conducteur par incorporation de particules conductrices et soudée aux couches externes par pressage à chaud, et en ce qu'ensuite, à une température comprise entre 50°C et 80°C, on lamine la préforme entre deux rouleaux, la tension de polarisation étant appliquée entre la couche interne et les rouleaux, et le pressage à chaud étant effectué à température plus élevée que le laminage de la préforme.

L'invention sera mieux comprise par la description ci-après et les figures l'accompagnant parmi lesquelles:
- la figure 1 est une vue en perspective d'un transducteur piézoélectrique;
- la figure 2 est une lame de polymère sur laquelle on a déposé une électrode en solution;
- la figure 3 représente un dispositif de colaminage sous champ électrique;
- la figure 4 représente une lame de polymère et une électrode intermédiaire sous forme de film.
- la figure 5 représente une préforme tubulaire a enduction interne;
- la figure 6 illustre l'emploi d'une presse pour aplatir une préforme tubulaire;
- la figure 7 est une vue en élévation d'un train de laminage à gorges et une vue en bout d'une préforme à laminer;
- la figure 8 illustre la coextrusion d'une préforme;
- les figures 9, 10 et 11 sont des vues en bout de préformes destinées à confectionner des rubans et des câbles piézoélectriques.

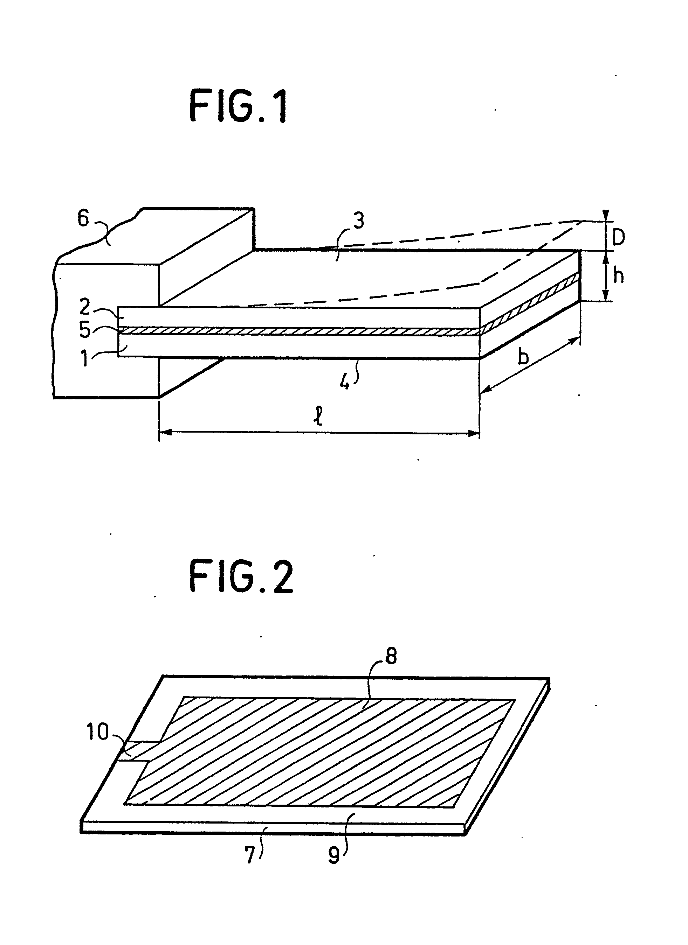

La figure 1 représente un transducteur piézoélectrique du type bimorphe, utilisé sous forme de poutre encastrée à une extrémité. Ce transducteur est formé de deux lames 1 et 2, recouvertes respectivement de métallisations 4 et 3 et d'une electrode intermediaire 5 enserrée entre les deux lames. Une extremite du transducteur est encastrée dans un socle fixe 6. On démontre que pour une flèche D résultant d'une force appliquée à l'extrémité libre du transducteur, il apparaît en circuit ouvert entre les électrodes 3 et 4, une tension V telle que:

$$V = \frac{3}{8} \cdot \frac{h^2}{L^2} \cdot \frac{d_{31}}{\varepsilon} \cdot D \cdot E$$

L étant la longueur libre du transducteur,
h son épaisseur,
$\varepsilon$ la constante diélectrique du matériau polymère, $d_{31}$ son coefficient piézoélectrique et E le module d'YOUNG du matériau.

Par ailleurs, on démontre également que la déformation D' d'un tel transducteur sous l'effet d'une tension V' appliquée entre les électrodes 3 et 4 et en l'absence de toute contrainte mécanique est:

$$D' = \frac{3}{2} \cdot \frac{l^2}{h^2} \, d_{31} \cdot V'$$

Les transducteurs bimorphes polymères, et en particulier ceux réalisés en polyfluorure de vinylidène (PVF$_2$) sont capables de très grandes flexions sous champ appliqué et peuvent engendrer de très fortes tensions par flexion. Afin de profiter au maximum de ces avantages, il est nécessaire de disposer de matériaux ayant les plus grands coefficients piézoélectriques $d_{31}$ possibles et de réussir à coller les deux films avec le minimum d'adhésif. Cet adhésif doit avoir un module d'YOUNG voisin ou plus faible que celui du polymère des lames pour des raisons de fiabilité mécanique. Il est souhaitable en plus d'utiliser une méthode de production aussi peu coûteuse que possible. Ces conditions sont remplies dans la technologie décrite ci-après qui fait l'objet de la présente demande de brevet.

Le choix de l'électrode intermédiaire en matériau polymère conducteur tient à plusieurs raisons. Tout d'abord, il s'agit de faire adhérer cette électrode aux deux lames du bimorphe. Ceci est d'autant mieux réalisé que les matériaux à assembler sont de natures voisines. Il faut ensuite que, pendant le laminage, l'électrode centrale puisse être étirée de plusieurs fois sa longueur sans perdre ses propriétés conductrices.

La meilleure solution consiste à disposer d'une électrode de même nature que les lames formant le bimorphe pour que l'adhérence soit réalisée dans les meilleures conditions possibles. On conçoit que lors du laminage, les problèmes dus à l'étirement des matériaux seront alors réduits au minimum. Le transducteur peut par exemple être réalisé entièrement en polyfluorure de vinylidène (PVF$_2$), l'électrode intermédiaire étant rendue conductrice par l'incorporation d'un matériau approprié. Du point de vue du fonctionnement du bimorphe, cette électrode est idéale, puisqu'elle peut être très mince, avec sensiblement les mêmes propriétés mécaniques que le matériau composant les lames. Enfin, la conductivité de telles électrodes est très suffisante pour l'opération de polarisation même en employant une charge de carbone peu coûteuse: 15 % de carbone en poids du type Corax L de la Société DEGUSSA procurent une résistivité d'environ 10 $\Omega$.cm, très inférieure à celle du PVF$_2$ en cours de laminage (résistivité environ: $10^{12}\Omega$.cm).

A titre d'exemple non limitatif, la description des solutions proposées concernera les bimorphes réalisés entièrement à partir de polyfluorure de vinylidène (PVF$_2$) aussi bien pour les lames que pour l'électrode intermédiaire.

Une première variante de l'invention consiste à déposer l'électrode intermédiaire sous forme de solution sur les lames à assembler. Une solution de PVF$_2$ conducteur peut être obtenue à partir d'un solvant tel que le diméthyl formamide (DMF) dans lequel on a dissous le matériau polymère de base et du carbone. Une solution obtenue dans les proportions suivantes:

DMF: 1 litre
PVP$_2$: 100 g
CORAX L: 20 g.

apporte entièrement satisfaction. La dissolution est effectuée pour une température de l'ordre de 80 à 90° C sous agitation pendant une heure. Cette solution est alors déposée en couche mince sur chacune des faces des lames de PVF$_2$ destinées à devenir les faces internes d'un futur bimorphe. Le dépôt de polymère PVP$_2$ conducteur en solution dans le diméthyl formamide crée une dissolution superficielle de la lame substrat et assure donc le dépôt d'une couche conductrice adhérente après évaporation du diméthyl formamide. Les lames de polymère PVP$_2$ peuvent être obtenues par compression-moulage ou extrusion de granulés. Le dépôt s'effectue à chaud: substrats et solutions sont portés à une température de l'ordre de 60 à 70° C. Des couches minces, d'environ 15 à 20 microns d'épaisseur, et régulières peuvent être obtenues par pulvérisation à l'aide d'un pistolet à peinture. D'autres méthodes, telles que la sérigraphie ou le dépôt à la tournette peuvent être utilisées.

La figure 2 est une vue en perspective d'une lame en polymère sur laquelle a été déposée une électrode conductrice en solution. On y aperçoit une lame 7 servant de substrat et l'électrode 8 déposée sous forme de solution. Une marge 9 non conductrice de 0,5 à 1 cm environ a été ménagée sur les films à laminer de façon à éviter des claquages électriques dans l'air, entre électrode centrale et rouleaux, lors du laminage. On a également prévu dans une zone 10 un dépôt de la même solution afin de ménager une languette conductrice qui servira de prise de contact pour la connexion de l'électrode vers un circuit extérieur. Environ 10 minutes après le dépôt des électrodes, on estime que l'évaporation du solvant est suffisante et les lames sont pressées entre elles, leurs deux électrodes étant en contact et les zones 10 se faisant face. Le pressage est effectué à environ 100° C pour une pression de 1 MPa 10 Kg/cm$^2$ pendant quelques minutes. On aura pris soin d'engager entre électrodes dans la zone de prise de contact, avant pressage, une feuille mince métallique pour assurer la connexion de l'électrode intermédiaire au générateur de tension de polarisation. Cette méthode de dépôt de l'électrode intermédiaire ainsi que le pressage réalisé par la suite assure une très bonne adhésion entre les divers constituants. L'ensemble est alors prêt au laminage sous champ électrique afin d'acquérir des propriétés piézoélectriques.

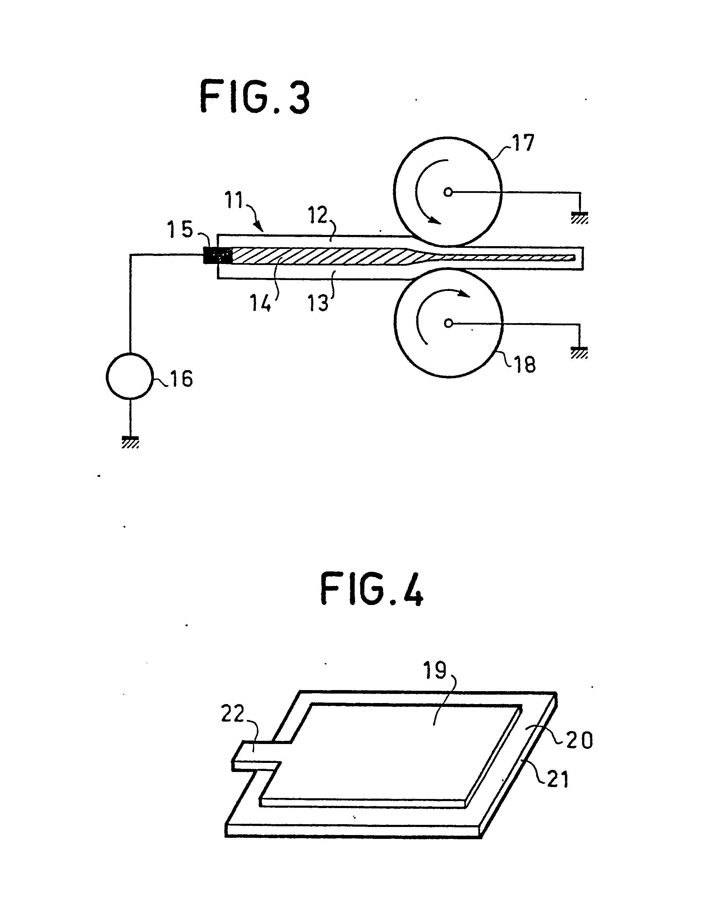

Le laminage sous champ peut être effectué selon la technique illustrée par la figure 3. On distingue l'ensemble 11 qui représente le produit obtenu précédemment après pressage et constitué par les lames 12 et 13 en polymère et l'électrode centrale 14. On aperrçoit également une feuille métallique 15 assurant la liaison électrique entre l'électrode intermédiaire et un générateur électrique de polarisation 16. L'ensemble 11 est passé au laminoir constitué principalement par les deux rouleaux conducteurs 17 et 18 tournant dans le sens indiqué par les flèches. Dans le cas où l'on désire des polarisations rémanentes de sens opposés par rapport à l'électrode intermédiaire, on peut mettre les deux rouleaux au potentiel de la masse comme l'indique la figure 3.

Les conditions de laminage sont par exemple les suivantes:
- forces entre rouleaux: $4.10^5$ à $10^6$ N (40 à 100 tonnes),
   - vitesse de défilement: 1 à 10 mm par minute,
   - tension appliquée: 10 à 20 kV,
   - épaisseur à l'entrée: de 100 microns à 1 cm,
   - diamètre des rouleaux: 8 cm,
   - taux d'étirement: 3 à 4,
   - température des rouleaux: de 50 à 80°C.

Les coefficients piézoélectriques obtenus sont de l'ordré de 20 à $30.10^{-12}$ CN$^{-1}$. Le système de contraintes mécaniques appliquées provoque la fusion des cristallites en phase $\alpha$ non polaire, suivie d'une recristallisation complète en phase $\beta$ polaire orientée mécaniquement et électriquement. Pour cette raison, les champs électriques appliqués sont modérés et les tensions à appliquer peu dépendantes de l'épaisseur du bimorphe. Des épaisseurs et des vitesses de défilement supérieures peuvent être obtenues avec des rouleaux de plus grands diamètres ou des rouleaux à surfaces dépolies.

Afin d'assurer a ces bimorphes la stabilité dimensionnelle dans le temps et pour des temperatures plus élevées que celles auxquelles ils ont été laminés, ainsi que pour garantir un comportement stable de l'activité piézoélectrique, ils sont recuits sous tension mécanique parallèlement à l'axe d'étirement ou sous presse, pour une température comprise entre 100 et 110°C et pendant une durée variable de 20 mn à 1 heure. Le retrait subséquent est de l'ordre de quelques pour cent et l'activité piézoélectrique baisse de 10 à 30% mais la stabilité est alors assurée jusqu'à une température de fonctionnement voisine de celle de la température de recuit.

Ces bimorphes sont ensuite métallisés simple ou double face, suivant l'utilisation à laquelle ils sont destinés, par évaporation d'aluminium ou de nickel-chrome. Une autre méthode consiste à déposer une couche de polymère chargé en particules d'argent du type DYNALOY 350 ou plus économiquement, surtout s'il s'agit de capteurs qui ne nécessitent pas de hautes conductivités d'électrodes, une couche de polymère PVF$_2$ à laquelle on a ajouté du noir de carbone, identique à celle utilisée pour l'électrode intermédiaire.

Une seconde variante de l'invention consiste à fabriquer l'électrode intermédiaire à partir de granulés de polymère chargés de particules de carbone conducteur. On peut disposer actuellement de granulés de polymère PVF$_2$ contenant une concentration de 20% en poids de carbone. A partir de ces granulés, il est possible d'obtenir des films d'épaisseur 100 microns ou moins, par les techniques de compression-moulage ou d'extrusion. De tels films peuvent être étirés pratiquement de 400% sans perte de conductivité ce qui correspond aux exigences du laminage.

La figure 4 représente l'électrode intermédiaire 19 ainsi réalisée et découpée de façon à laisser une marge 20 non conductrice lorsqu'elle est posée sur un substrat polymère 21 qui peut être par exemple un polymère PVF$_2$. La découpe permet également l'accès électrique à l'électrode par la présence de la languette 22 qui déborde du substrat 21. On empile une première lame polymère, l'électrode intermédiaire et une seconde lame polymère afin de réaliser une structure bimorphe. L'ensemble est ensuite pressé à une témperature d'environ 165°C pendant environ 15 minutes, à une pression d'à peu pres 10 MPa (10 Kg/cm$^2$. Pendant l'opération l'ensemble est placé entre des cales fixes d'épaisseur légèrement inférieure à celle de l'empilement afin d'éviter son fluage. Ce pressage réalise une véritable soudure des trois composants du bimorphe qui est indestructible lors du laminage. Cette technologie est plus simple que la précédente. Toutefois, elle serait plus indiquée pour la fabrication de bimorphes épais (de l'ordre de quelques centaines de microns). En effet, il est difficile d'obtenir une épaisseur régulière pour l'électrode intermédiaire en-deça d'une épaisseur initiale de 50 à 100 microns, qui peut être ramenée à environ 12 à 25 microns après laminage. Le laminage sous champ électrique peut être ensuite effectué dans les mêmes conditions que celles décrites précédemment.

Il entre également dans le cadre de l'invention de réaliser l'électrode centrale à partir d'un autre polymère que le polymère constituant les lames du bimorphe.

La fabrication de transducteurs piézoélectriques polymères bimorphes selon l'invention a l'avantage de développer un produit possédant des qualités mécaniques et électriques excellentes. Ces bimorphes peuvent être utilisés en transducteurs émetteurs et/ou capteurs électroacoustiques.

Jusqu'ici on a considéré des structures formées par l'assemblage de feuillets en polymère et reliés entre eux par un liant polymère conducteur qui assure la conservation de l'intégralité de la structure lorsqu'elle subit le laminage sous champ électrique. Une telle structure est une préforme dont tous les constituants supportent des allongements importants. Sans s'écarter du domaine de l'invention, on peut également envisager le laminage sous champ électrique de préformes d'un genre différent.

De telles préformes sont caractérisées par le fait que le polymère forme une enveloppe tubulaire.

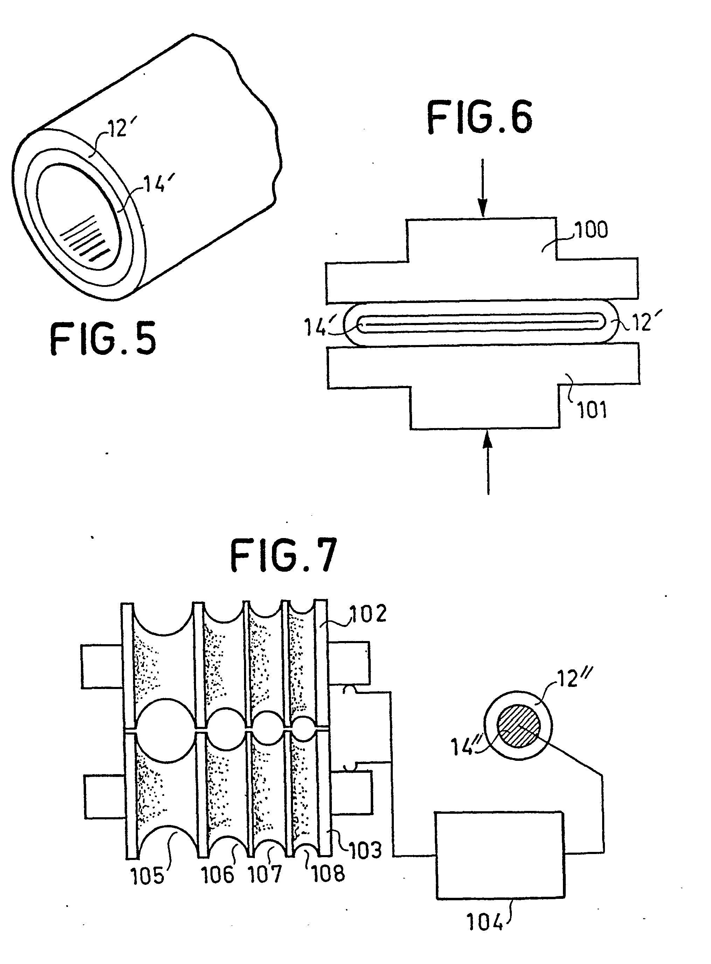

Sur la figure 5, on peut voir une telle préforme. Elle est constituée par un tube 12' de polymère extrudé dont la face interne est revêtue d'une couche 14' de polymere conducteur. Cette couche interne 14' peut être obtenue par enduction ou par co-extrusion avec le tube 12'.

Pour obtenir une préforme aplatie, on voit sur la figure 6 que le tube de la figure 5 peut être écrasé entre les plateaux 100 et 101 d'une presse. L'avantage d'une telle préforme est que le matériau conducteur 14' reste confiné a l'interieur de l'enveloppe 12'. Le laminage sous champ électrique d'une telle préforme peut se faire entre deux cylindres parallèles a génératrices rectilignes.

Il est également possible d'envisager une préforme à section circulaire coaxiale comme illustré sur la figure 7.

La figure 7 montre un train de laminoir à gorges 102, 103 dont les "cylindres" sont reliés à la masse d'un générateur 104 de tension de polarisation. La préforme se compose d'une structure en forme de câble à section circulaire dont l'âme 14" est realisée en polymère conducteur et l'enveloppe 12" en polymère tel que le PVF$_2$. En plusieurs passes de laminage cette préforme donne naissance à une fibre piézoélectrique à polarisation radiale. A cet effet, lors du laminage, l'âme conductrice 14" est reliée au générateur électrique 104. Les gorges 105, 106, 107 et 108 ont des formes toroidales de plus en plus serrées lorsque le laminage se fait en plusieurs passes. On peut aussi utiliser plusieurs trains pour laminer collectivement plusieurs préformes.

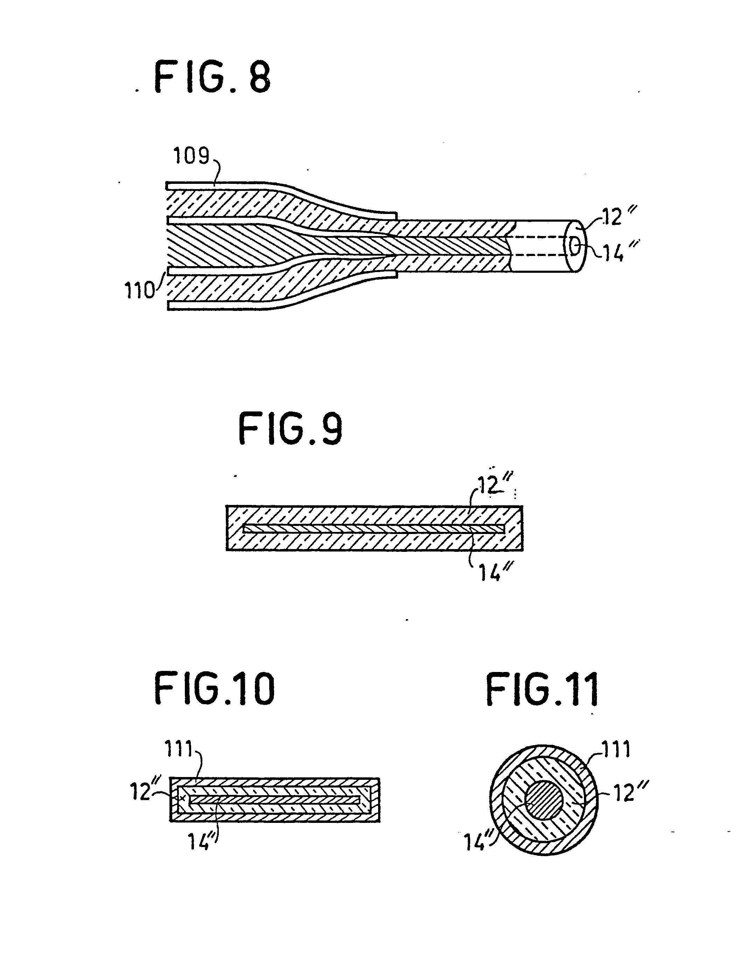

Pour obtenir une préforme dans laquelle une électrode conductrice forme l'âme d'un câble, on utilisera avantageusement la technique de coextrusion illustrée sur la figure 8. Le polymère 12" et le polymère conducteur 14" sont injectés à chaud dans des filiéres coaxiales 109 et 110. Cette technique permet d'obtenir directement les formes représentées aux figures 9, 10 et 11. La référence 111 des figures 10 et 11 désigne une gaine en polymère conducteur qui peut être co-extrudée ou obtenue au trempé.

Lorsque la section d'une préforme est circulaire coaxiale, la polarisation créée au cours du laminage est radiale.

## Revendications

1. Procédé de fabrication d'un transducteur en polymère rendu piézoélectrique par étirage mécanique à chaud et polarisation simultanée sous l'action d'un champ électrique, caractérisé en ce qu'on réalise d'abord une préforme composée de deux couches externes (12, 13) de matériau polymère susceptible d'acquérir des propriétés piézoélectriques séparées par une couche interne (14), constituée d'un matériau polymère rendu conducteur par incorporation de particules conductrices et soudée aux couches externes par pressage à chaud, et en ce qu'ensuite, a une température comprise entre 50°C et 80°C, on lamine la préforme entre deux rouleaux (17, 18), la tension de polarisation étant appliquée entre la couche interne (14) et les rouleaux (17, 18), et le pressage à chaud etant effectué à température plus élevée que le laminage de la préforme.

2. Procédé selon la revendication 1, caractérisé en ce que pour réaliser cette préforme on utilise une solution du polymère formant la couche centrale, cette solution contenant une dispersion de particules conductrices, que l'on enduit les faces en regard des couches extérieures avec cette solution, et que l'on maintient en contact les faces ainsi enduites jusqu'à ce que le solvant de la solution soit évaporé.

3. Procédé selon la revendication 2, caractérisé en ce que les trois couches (12 - 14) sont en PVF$_2$, que le pressage de la préforme s'effectue à une température sensiblement égale à 100°C et le laminage à une température comprise entre 50 et 80°C.

4. Procédé selon la revendication 1, caractérisé en ce que pour réaliser cette préforme on fabrique séparément les trois couches et qu'on les soude entre elles par pressage à chaud.

5. Procédé selon la revendication 2, caractérisé en ce que les trois couches (12 - 14) sont en PVF$_2$, que le pressage de la préforme s'effectue à une température sensiblement egale à 165°C et le laminage à une temperature comprise entre 50 et 80°C.

6. Procédé selon la revendication 1, caractérisé en ce que pour réaliser cette préforme on fabrique tout d'abord par coextrusion un tube comportant une couche extérieure (12) de polymère susceptible de devenir piézoélectrique et une couche intérieure (14) de polymère rendu conducteur, et que l'on écrase ensuite ce tube entre les plateaux (100, 101) d'une presse pour obtenir la préforme.

7. Procédé selon la revendication 1, caractérisé en ce que pour réaliser cette préforme on coextrude une couche plate (14) de polymère rendu conducteur et une couche (12) de polymère susceptible de devenir piézoélectrique et qui entoure la couche plate conductrice.

## Patentansprüche

1. Herstellungsverfahren für einen Wandler aus einem Polymer, der durch mechanisches Warmstrecken und gleichzeitiges Polarisieren unter der Einwirkung eines elektrischen Felds piezoelektrisch gemacht ist, dadurch gekennzeichnet, daß zunächst ein Vorformling hergestellt wird, der aus zwei äußeren Schichten (12, 13) aus einem Polymer, das piezoelektrische Eigenschaften annehmen kann, und einer inneren Schicht (14) gebildet ist, welche aus einem durch das Beimengen von leitenden Teilchen leitend gemachten Polymer besteht und an die äußeren Schichten durch ein Warmpressen geschweißt ist, und daß dann bei einer Temperatur zwischen 50° C und 80° C der Vorformling zwischen zwei Rollen (17, 18) gewalzt wird, wobei die Polarisierspannung zwischen der inneren Schicht (14) und den Rollen (17, 18) angelegt wird, und das Warmpressen bei einer höheren Temperatur als das Walzen des Vorformlings vorgenommen wird.

2. Verfahren nach Anspruch 1, dadurch gekennzeichnet, daß zum Herstellen des Vorformlings eine Polymerlösung, die die mittlere Schicht bildet, benützt wird, wobei die Lösung eine Dispersion von leitenden Teilchen enthält, daß die gegenüberstehenden Flächen der äußeren Schichten mit der Lösung überzogen werden und daß die so überzogenen Flächen in Kontakt gehalten werden, bis das Lösungsmittel der Lösung verdampft ist.

3. Verfahren nach Anspruch 2, dadurch gekennzeichnet, daß die drei Schichten (12 bis 14) aus PVF$_2$ bestehen, daß das Pressen des Vorformlings bei einer Temperatur ungefähr gleich 100 Grad Celsius und das Strecken bei einer Temperatur zwischen 50 und 80 Grad Celsius stattfindet.

4. Verfahren nach Anspruch 1, dadurch gekennzeichnet, daß zum Herstellen des Vorformlings die drei Schichten getrennt gefertigt werden und daß sie durch Warmpressen miteinander verschweißt werden.

5. Verfahren nach Anspruch 2, dadurch gekennzeichnet, daß die drei Schichten (12 bis 14) aus PVF$_2$ bestehen, daß das Pressen des Vorformlings bei einer Temperatur ungefähr gleich 165 Grad Celsius und das Strecken bei einer Temperatur zwischen 50 und 80 Grad Celsius stattfindet.

6. Verfahren nach Anspruch 1, dadurch gekennzeichnet, daß zum Herstellen des Vorformlings durch Coextrusion ein Rohr mit einer äußeren Schicht (12) aus Polymer, das piezoelektrisch werden kann, und einer leitend gemachten inneren Schicht (14) aus Polymer gefertigt wird und daß dann das Rohr zwischen den Platten (100, 101) einer Presse zusammengedrückt wird, um den Vorformling zu erhalten.

7. Verfahren nach Anspruch 1, dadurch gekennzeichnet, daß zum Herstellen des Vorformlings eine leitend gemachte ebene Schicht (14) aus Polymer und eine Schicht (12) aus Polymer, die piezoelektrisch werden kann und die die leitende ebene Schicht umgibt, coextrudiert werden.

## Claims

1. Method of fabricating a transducer from a polymer rendered piezoelectric by mechanical hot stretching and simultaneous polarization under the action of an electrical field, characterized in that firstly a preform is made composed of two outer layers (12, 13) of polymer material capable of assuming piezoelectric properties and separated by an inner layer (14) constituted by a polymer material rendered conductive by incorporation of conductive particles and welded to the outer layers by hot pressing, and that thereafter at a temperature between 50 degrees C and 80 degrees C the preform is rolled between two rollers (17, 18), the polarization voltage being applied between the inner layer (14) and the rollers (17, 18) and the hot pressing being carried out at a higher temperature than the rolling of the preform.

2. Method according to claim 1, characterized in that to make said preform a polymer solution is used forming the centre layer, said solution containing a dispersion of conductive particles, that the opposite faces of the outer layers are coated with said solution, and that the faces coated in this manner are maintained in contact until the solvent of the solution is evaporated.

3. Method according to claim 2, characterized in that the three layers (12 to 14) consist of PVF$_2$, that the pressing of the preform is effected at a temperature substantially equal to 100 degrees C and the rolling at a temperature between 50 and 80 degrees C.

4. Method according to claim 1, characterized in that to make said preform the three layers are separately made and welded together by hot pressing.

5. Method according to claim 2, characterized in that the three layers (12 to 14) consist of PVF$_2$, that the pressing of the preform is carried out at a temperature substantially equal to 165 degrees C and the rolling at a temperature between 50 and 80 degrees C.

6. Method according to claim 1, characterized in that to make said preform firstly by coextrusion a tube is made comprising an outer layer (12) of polymer capable of becoming piezoelectric and an inner layer (14) of polymer rendered conductive and that thereafter said tube is pressed between the plates (100, 101) of a press for obtaining the preform.

7. Method according to claim 1, characterized in that to make said preform a planar layer (14) of polymer rendered conductive and a layer (12) of polymer capable of becoming piezoelectric and surrounding the planar conductive layer are coextruded.

# FIG.1

# FIG.2

# FIG.3

# FIG.4

FIG.5

FIG.6

FIG.7

## FIG. 8

## FIG.9

## FIG.10

## FIG.11